Europäisches Patentamt

(19) **European Patent Office**

**Office européen des brevets**

(11) Publication number: **0 028 700**
**B1**

(12) **EUROPEAN PATENT SPECIFICATION**

(45) Date of publication of patent specification: **04.05.83**

(51) Int. Cl.³: **H 01 L 21/60** //H01L21/68

(21) Application number: **80105796.9**

(22) Date of filing: **25.09.80**

(54) Method and apparatus for removing a semiconductor chip from a substrate.

(30) Priority: **13.11.79 US 93321**

(43) Date of publication of application:
**20.05.81 Bulletin 81/20**

(45) Publication of the grant of the patent:
**04.05.83 Bulletin 83/18**

(84) Designated Contracting States:
**DE FR GB**

(56) References cited:
**IBM TECHNICAL DISCLOSURE BULLETIN, vol. 19, no. 3, August 1976, pages 939—940 New York, U.S.A.**
**IBM TECHNICAL DISCLOSURE BULLETIN, vol. 13, no. 7, December 1970, pages 1811—1812.**

(73) Proprietor: **International Business Machines Corporation**
**Armonk, N.Y. 10504 (US)**

(72) Inventor: **Shariff, Rafique Siddique**
**Route 55**
**LaGrangeville New York 12540 (US)**

(74) Representative: **Richards, John Peter**
**IBM UNITED KINGDOM PATENT OPERATIONS**
**Hursley Park**
**Winchester Hants, SO21 2JN (GB)**

Courier Press, Leamington Spa, England.

Method and apparatus for removing a semiconductor chip from a substrate

The present invention relates to a method and apparatus for removing a semiconductor chip from a substrate.

In certain integrated circuit layouts, a plurality of monolithic semiconductor devices are mounted on an insulating substrate having an electrical interconnection network that interconnects the semiconductor circuit chips. The chips are mounted at chip sites on the substrate by solder columns that join terminals of the chips to the pads on the interconnection network.

One technique for forming these solder columns involves fusing solder balls at each of the chip terminals to pads on the substrate with a solder reflow technique. This technique is described in U.S. Patent 3,429,040, and in the article "A Critique of Chip Joinings Techniques" by L. F. Miller, beginning on page 50 of the April, 1970 issue of Solid State Technology.

With a large number of semiconductor chips on a substrate, it becomes necessary from time to time to remove a defective chip from the substrate and replace it with an operative chip. One technique for removing the defective chip is to repeatedly twist the chip relative to the substrate until the solder columns rupture. This removal technique has a number of problems. One of them is that it leaves a residue from the solder columns at the chip site which must be removed before a new chip can be attached to the substrate at that site. Another problem with the technique is that it sometimes results in damage to the interconnection network on the substrate.

One method for removing the residue of the solder columns from the chip site can be found in our copending European Application 80102082.7 (PO9—78—019) (EP—A—18557). In this method, a mask is placed over the chip site. This mask has holes in it that expose the remnants of the solder columns while shielding the remainder of the chip site. A brush is then used to remove the excess solder of the remnants.

A difficulty with this chip site dressing method is that in order for it to work satisfactorily the remnant solder columns must be substantially perpendicular to fit through the openings in the mask. If they are bent during the removal of the chip, which frequently happens with the above-described chip removal technique, the mask will not fit over the residue of the solder columns and the dressing technique cannot be employed. Furthermore, the dressing method does not compensate for the removal of too much solder from the chip site by the chip removal technique.

Therefore, in accordance with the present invention, an improved chip removal method using cooling is provided which substantially reduces the stress on the substrate at the chip site and leaves remnant solder columns that are substantially vertical. In this method the solder columns are chilled until they become brittle, and then the columns are ruptured by a slight movement of the chip relative to the substrate. The movement may be a twisting movement as in the prior technique described above, but it is only necessary to perform this delicately through a very small angle, resulting in the columns breaking off somewhere at their midpoints without substantial bending of the columns. Furthermore, the number of twisting motions necessary is reduced. Due to the very small exertion of force during the breaking of the columns at their midpoints, little damage is done to the substrate or its interconnection network. In addition, the verticality and size of the remnant columns enable the efficient use of the solder column residue removal method described in our copending application.

To perform this removal operation, a tool is described which has a conduit that directs cooling fluid into a chamber in a shroud. The shroud has an opening which fits over the chip so that the upper surface of the chip is exposed to fluid entering the chamber from the conduit. The opening is configured to the form of the chip and is slightly larger than the chip at room temperature so that it fits easily over the chip selected for removing. However, the coefficient of thermal expansion of the shroud is greater than that of the chip so that when the cooling fluid enters the chamber within the shroud, the cooling of the shroud causes the opening in the shroud to shrink resulting in the sidewalls of the opening clamping against the chip and sealing the chamber to prevent the cooling fluid from thereafter contacting the surface of the substrate and causing thermal shock to the interconnection network on the substrate. The clamping of the chip also facilitates the solder columns and removal of the chip from the chip site, which can both be performed by manipulation of the shroud.

An embodiment of the present invention will now be described with reference to the accompanying drawings, in which:

Figure 1 is a perspective view of a tool being used to remove a chip from a semiconductor substrate;

Figure 2 is a section along line 22 in Figure 1; and

Figure 3 is a side view of one of the chips on the substrate shown in Figure 1.

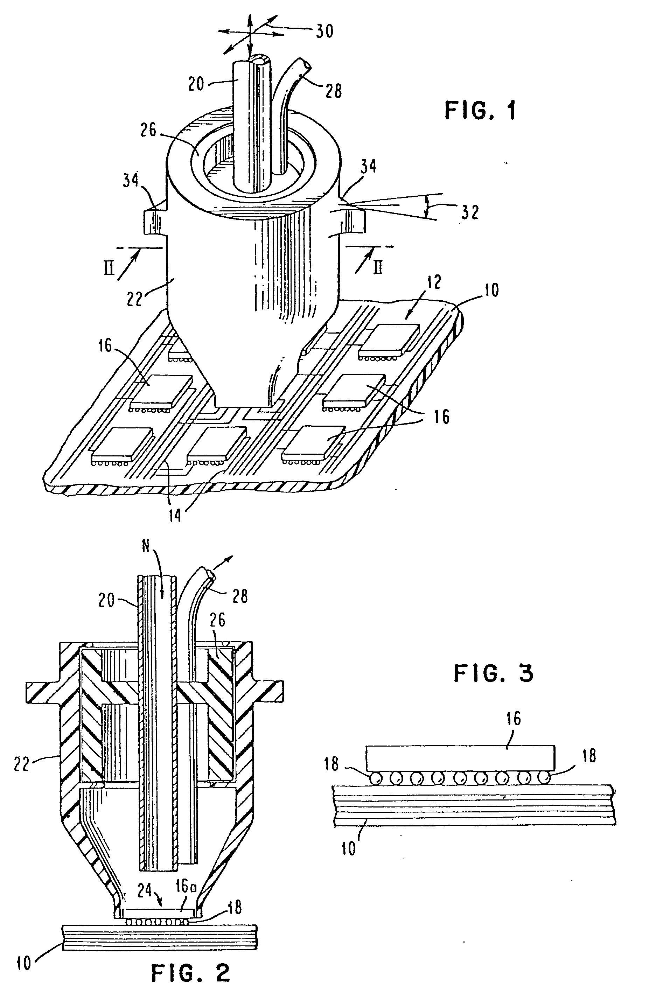

Referring to Figure 1, an insulating substrate 10 has a plurality of chip connection sites 12 thereon in an interconnection network 14 that connects the chip sites to one another and to terminal pins (not shown) of the substrate 10. The substrate is a multi-layer ceramic substrate of known type with the interconnection network on its top surface and disposed between its various layers.

Because of its complexity, the substrate package is expensive relative to any one of the chips mounted thereon. Therefore, when one of the chips is defective, it is desirable to remove the defective chip and replace it with a good chip to salvage the substrate package.

Monolithic semiconductor integrated circuit chips 16 are mounted at the chip sites 12 on solder columns 18 (see Fig. 3) that connect the circuits on the chip to the interconnection network 14. These solder columns 18 are formed by fusing solder balls at each of the chip terminals to corresponding pads in the interconnection network 14 by solder reflow. In Figure 3, a single representative row of nine columns 18 are shown. In an actual chip, there could be many more solder columns in a row, and there would also be a number of such rows.

As shown in Figures 1 and 2, a pipe 20 is suspended over a defective chip 16a that is to be removed with the lower opening in the pipe directly over the surface of the chip opposite the solder columns. This pipe 20 is positioned within a generally cylindrical shroud 22 that tapers at one end to a square opening 24 only slightly larger than the chip, which is also square. The square opening is fitted over the chip 16a for removal of the chip. The pipe 20 is force fitted in an opening through a cylindrical member 26 located for rotation relative to the shroud between two annular ribs in the interior wall of the shroud. In addition to the pipe 20 for introduction of cooling fluid into the chamber formed by the shroud, there is a second pipe 28 for exhausting gas from the chamber which is force fitted through a further opening in the cylindrical member 26.

The shroud is mounted for movement along three mutually perpendicular axes 30 so that it can be moved horizontally over the surface of the substrate to any position, and its height changed enabling the device to be easily placed over any selected defective chip on the substrate 10 such as the defective chip 16a. In addition, the shroud 22 can be rotated in a horizontal plane as indicated at 32. Since the member 26 is not rigidly fixed to the shroud 22, but merely rotates between the ribs, such rotation of the shroud can be effected without putting undue strain on the pipes 20 and 28. Both the shroud 22 and the cylindrical member 26 are made of a self lubricating plastic such as polytetrafloroethylene. The cooling liquid is liquid nitrogen and the pipes are copper.

In operation, the shroud 22 is moved until it is positioned over the defective chip 16a with the defective chip positioned in the opening 24 of the shroud 22. Then the liquid nitrogen is sprayed into the cavity through the pipe 20 causing the shroud to shrink and in shrinking, clamp the sidewalls of the opening 24 to the edges of the chip 16a preventing the liquid nitrogen spray from escaping through the opening and thereby avoiding thermal damage to the substrate of the interconnection networks. The spray also cools the chip 16a and solder columns 18. This localized cooling is in the range of approximately −10 to −20 degrees celsius. Due to this cooling, the solder columns become embrittled and snap quite easily when the shroud 22 is hand twisted (using the members 34) back and forth a few times (3 to 5) through a small angular displacement (±1 degree). The solder columns 18 break at about their midpoint and do so without significant bending making them ideal for dressing the site for a new chip in accordance with the dressing technique of the above mentioned copending patent application.

## Claims

1. A method of removing a semiconductor chip (16a) attached to a substrate (10) by a plurality of solder columns (18), characterised by the steps of chilling the columns (18) to cause embrittlement thereof, rupturing the columns so chilled by slight movement of the chip relative to the substrate, and thereafter moving the chip away from the substrate.

2. The method of claim 1, wherein the movement of the chip is a slight rotational motion.

3. The method of claim 1 or 2, wherein the columns are chilled by application of a cooling substance to the opposite side of the chip to the columns.

4. The method of claim 3, wherein the cooling substance is a liquefied gas.

5. The method of claim 3 or 4, wherein the cooling substance is applied to the chip in a shroud which substantially shields the substrate from the cooling substance.

6. The method of claim 5, wherein the shroud is designed to shrink slightly when the cooling substance is applied to the chip so as to grip the chip, and wherein the movement of the chip to rupture the chilled columns is effected by moving the shroud.

7. Apparatus for removing a semiconductor chip (16a) attached to a substrate (10) by a plurality of solder columns (18), characterised by a conduit (20) for applying a cooling fluid to the opposite surface of the chip to the columns, a shroud (22) forming a chamber around the end of the conduit to substantially prevent the fluid from contacting the substrate, the shroud having an opening (24) to the chamber substantially conforming to the shape of the chip, the opening being slightly larger than the chip at room temperature and the shroud being formed of a material which has a coefficient of thermal expansion which is greater than that of the chip so that the opening shrinks relative to the chip and seals against the sides of the chip when the cooling fluid is introduced into the chamber, and means (34) permitting at least a slight rotational movement of the shroud when the chip is clamped within the opening.

8. The apparatus of claim 7, wherein the conduit is supported in the shroud by an element (26) rotatable relative to the shroud so that the shroud can be rotated without imparting rotation to the conduit.

## Revendications

1. Un procédé pour enlever une microplaquette semi-conductrice (16a) fixée à un substrat (10) par plusieurs colonnes de soudure (18), caractérisé par les étapes de refroidissement des colonnes (18) pour qu'elles présentent une dureté cassante, de rupture des colonnes ainsi rendues cassantes par un léger mouvement de la microplaquette par rapport au substrat et ensuite, d'effectuer un mouvement de la microplaquette par rapport au substrat.

2. Le procédé de la revendication 1 dans lequel le mouvement de la microplaquette est un léger mouvement en rotation.

3. Le procédé de la revendication 1 ou 2 dans lequel les colonnes sont refroidies par application d'une substance de refroidissement au côté de la microplaquette opposé aux colonnes.

4. La procédé de la revendication 3 dans lequel la substance de refroidissement est un gaz liquéfié.

5. Le procédé de la revendication 3 ou 4 dans lequel la substance de refroidissement est appliquée à la microplaquette dans une enveloppe qui isole pratiquement le substrat de la substance de refroidissement.

6. Le procédé de la revendication 5 dans lequel l'enveloppe est conçue pour se contracter légèrement lorsque la substance de refroidissement est appliquée à la microplaquette de façon à saisir la microplaquette, et dans lequel le mouvement de la microplaquette, pour briser les colonnes refroidies, est assuré par le mouvement de l'enveloppe.

7. Appareil pour enlever une microplaquette semi-conductrice (16a) fixée à un substrat (10) par plusieurs colonnes de soudure (18), caractérisé par un conduit (20) pour l'application d'un fluide de refroidissement à la surface de la microplaquette opposée aux colonnes, une enveloppe (22) définissant une chambre autour de l'extrémité du conduit afin d'éviter tout contact entre le fluide et le substrat, l'enveloppe présentant une ouverture (24) réalisé dans la chambre et pratiquement conforme à la forme de la microplaquette, l'ouverture étant légèrement plus grande que la microplaquette à température ambiante et l'enveloppe étant formée d'un matériau présentant un coefficient de dilatation thermique supérieur à celui de la microplaquette si bien que l'ouverture se rétrécit par rapport à la microplaquette et s'applique hermétiquement contre les côtés de celle-ci lorsque le fluide de refroidissement est introduit dans la chambre et des moyens (34) permettant au moins un léger mouvement rotatif de l'enveloppe lorsque la microplaquette est bloquée dans l'ouverture.

8. L'appareil de la revendication 7 dans lequel le conduit est supporté, dans l'enveloppe, par un élément (26) pouvant tourner par rapport à l'enveloppe de façon que l'enveloppe puisse être entraînée en rotation sans appliquer de mouvement rotatif au conduit.

## Patentansprüche

1. Verfahren zum Entfernen eines durch eine Vielzahl von Lotstützen (18) an einem Substrat (10) befestigten Halbleiterchips (16a), gekennzeichnet durch die Schritte des Abschreckens der Stützen (18), um deren Sprödewerden zu verursachen, Abbrechen der so abgeschreckten Stützen durch leichtes Bewegen des Chips relativ zu dem Substrat und anschließendes Entfernen des Chips von dem Substrat.

2. Verfahren nach Anspruch 1, bei dem die Bewegung des Chips eine leichte Drehbewegung ist.

3. Verfahren nach Anspruch 1 oder 2, bei dem die Stützen durch Aufbringen einer Kühlsubstanz auf die der Seite mit den Stützen entgegengesetzten Seite des Chips abgeschreckt werden.

4. Verfahren nach Anspruch 3, bei dem die Kühlsubstanz ein verflüssigtes Gas ist.

5. Verfahren nach Anspruch 3 oder 4, bei dem die Kühlsubstanz in einer Hülse auf das Chip aufgebracht wird, die das Substrat im wesentlichen von der Kühlsubstanz abschirmt.

6. Verfahren nach Anspruch 5, bei dem die Hülse so entworfen ist, daß sie leicht schrumpft, wenn die Kühlsubstanz auf das Chip aufgebracht wird und die Hülse das Chip festhält, und bei dem die Bewegung des Chips zum Abbrechen der abgeschreckten Stützen durch Bewegen der Hülse bewirkt wird.

7. Vorrichtung zum Entfernen eines durch eine Vielzahl von Lotstützen (18) an einem Substrat (10) befestigten Halbleiterchips (16a), gekennzeichnet durch ein Rohr (20) zum Aufbringen einer Kühlflüssigkeit auf die der Fläche mit den Stützen entgegengesetzte Fläche des Chips, eine Hülse (22), die eine Kammer um das Ende des Rohres bildet, um im wesentlichen die Flüssigkeit an dem Berühren des Substrats zu hindern, wobei die Hülse eine Öffnung (24) zu der Kammer hin aufweist, die im wesentlichen der Form des Chips entspricht, wobei die Öffnung etwas größer ist als das Chip bei Raumtemperatur und die Hülse aus einem Material geformt ist, das einen Ausdehnungskeffizienten besitzt, der größer ist als der des Chips, so daß die Öffnung relativ zum Chip schrumpft und die Seiten des Chips abdichtet, wenn die Kühlflüssigkeit in die Kammer eingeführt ist, und durch Mittel (34), die zumindest eine leichte Drehbewegung gestatten, wenn das Chip in der Öffnung eingeklemmt ist.

8. Vorrichtung nach Anspruch 7, bei der das Rohr in der Hülse durch ein Element (26) getragen wird, das relativ zur Hülse drehbar ist, so daß die Hülse gedreht werden kann, ohne dem Rohr eine Drehbewegung zu erteilen.

FIG. 1

FIG. 3

FIG. 2